(19) Europäisches Patentamt
European Patent Office
Office européen des brevets

(11) Veröffentlichungsnummer : **0 111 273**
**B1**

(12) # EUROPÄISCHE PATENTSCHRIFT

(45) Veröffentlichungstag der Patentschrift : **04.03.87**

(51) Int. Cl.[4] : **G 03 F 7/08**

(21) Anmeldenummer : **83112141.3**

(22) Anmeldetag : **02.12.83**

(54) **Lichtempfindliches Gemisch, daraus hergestelltes lichtempfindliches Kopiermaterial und Verfahren zur Herstellung einer Druckform aus dem Kopiermaterial.**

(30) Priorität : **09.12.82 DE 3246037**

(43) Veröffentlichungstag der Anmeldung : **20.06.84 Patentblatt 84/25**

(45) Bekanntmachung des Hinweises auf die Patenterteilung : **04.03.87 Patentblatt 87/10**

(84) Benannte Vertragsstaaten : **AT BE CH DE FR GB IT LI NL SE**

(56) Entgegenhaltungen : **Keine Entgegenhaltungen**

(73) Patentinhaber : **HOECHST AKTIENGESELLSCHAFT**
**Postfach 80 03 20**
**D-6230 Frankfurt am Main 80 (DE)**

(72) Erfinder : **Stahlhofen, Paul, Dr.**
**Leibnizstrasse 18b**
**D-6200 Wiesbaden (DE)**
Erfinder : **Hsieh, Shane**
**4, Linvale Lane**
**Bridgewater New Jersey 08807 (US)**

**EP 0 111 273 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein lichtempfindliches Gemisch, das ein wasserunlösliches, in wäßrig-alkalischen Lösungen lösliches Bindemittel und eine lichtempfindliche Verbindung enthält, ein lichtempfindliches Kopiermaterial aus einem Schichtträger und einer lichtempfindlichen Schicht, die aus dem Gemisch besteht, sowie ein Verfahren zur Herstellung einer Druckform durch Belichten, Entwikkeln und Erhitzen des Kopiermaterials.

Verfahren zur Herstellung von Druckformen durch Erhitzen bzw. Einbrennen der Bildschicht von belichteten und entwickelten Kopiermaterialien sind z. B. aus den britischen Patentschriften 1 151 199 und 1 154 749 bekannt. Dabei wird entweder ein positiv arbeitendes, bevorzugt ein o-Chinondiazid enthaltendes, oder ein negativ arbeitendes, bevorzugt ein p-Chinondiazid enthaltendes lichtempfindliches Kopiermaterial bildmäßig belichtet, entwickelt und danach auf eine oberhalb 180 °C liegende Temperatur so lange und so hoch erhitzt, daß der zuvor sauber entwickelte Bildhintergrund durch Wärmezersetzungsprodukte der Bildschicht verschmutzt wird. Danach wird der Bildhintergrund durch nochmaliges Behandeln mit Entwicklerlösung wieder gesäubert. Normalerweise werden beim Erhitzen Temperaturen von 220-240 °C angewendet, und die Dauer des Erhitzens beträgt etwa 5-60 Minuten. Durch diese Nachbehandlung wird eine Verfestigung der Druckschicht und damit eine erhebliche Erhöhung der Druckauflage erreicht. Wenn die Einbrenntemperaturen an der oberen Grenze des angegebenen Bereichs liegen, sind naturgemäß relativ kurze Einbrennzeiten erforderlich. Es hat sich gezeigt, daß die Anwendung höherer Temperaturen bei diesem Verfahren nachteilig ist. Sie bewirken einmal die Ausbildung eines verhältnismäßig festsitzenden Niederschlags auf den Hintergrundstellen, der nur durch relativ aggressive Lösungen sauber entfernt werden kann, wobei auch die Gefahr eines Angriffs auf die Druckschablone besteht. Zum zweiten besteht bei den höheren Einbrenntemperaturen oder bei längeren Einbrennzeiten die Gefahr, daß sich die üblicherweise verwendeten Schichtträger aus Aluminium verformen und die erhaltenen Druckformen geschädigt oder unbrauchbar werden.

Der zuerstgenannte Nachteil kann, wie es in der DE-OS 26 26 473 beschrieben ist, dadurch vermieden werden, daß man die Hintergrundfläche vor dem Einbrennen mit einer Schicht einer wasserlöslichen organischen Substanz oder eines anorganischen Salzes überzieht, die sich nach dem Einbrennen leicht abwaschen läßt. Um die Verformung des Trägers zu verhindern, wäre es jedoch wünschenswert, bei tieferen Temperaturen einbrennen zu können.

Aus der DE-A 30 39 926 ist ein lichtempfindliches Gemisch der hier beschriebenen Gattung bekannt, das neben einer lichtempfindlichen Verbindung und einem alkalilöslichen Bindemittel ein Phenolderivat mit 2-4 Hydroxymethylgruppen enthält. Durch Zusatz des Phenolderivats läßt sich die Einbrenntemperatur unter 200 °C absenken. Dieses Material hat den Nachteil einer unbefriedigenden Entwicklerresistenz und einer weichen Gradation. Vor allem weist es eine geringere Lagerfähigkeit auf, die durch den Gehalt an reaktionsfähigem Phenolderivat verursacht wird.

Aufgabe der Erfindung war es, ein lichtempfindliches Gemisch bzw. ein daraus hergestelltes Kopiermaterial bereitzustellen, das ein Einbrennen bei niedrigeren Temperaturen erlaubt, ohne daß zugleich die Lagerfähigkeit und Entwicklerresistenz zurückgehen.

Die Erfindung geht aus von einem lichtempfindlichen Gemisch, das ein wasserunlösliches, in wäßrig-alkalischen Lösungen lösliches Bindemittel, ein lichtempfindliches o- oder p-Chinondiazid, ein Diazoniumsalz-Polykondensationsprodukt oder ein Gemisch aus

a) einer bei Belichtung Säure abspaltenden Verbindung und

b) einer Verbindung mit mindestens einer durch Säure spaltbaren C—O—C-Gruppe

und eine thermisch vernetzende Verbindung enthält.

Das erfindungsgemäße Gemisch ist dadurch gekennzeichnet, daß die thermisch vernetzende Verbindung ein cyclisches Säureamid der allgemeinen Formel

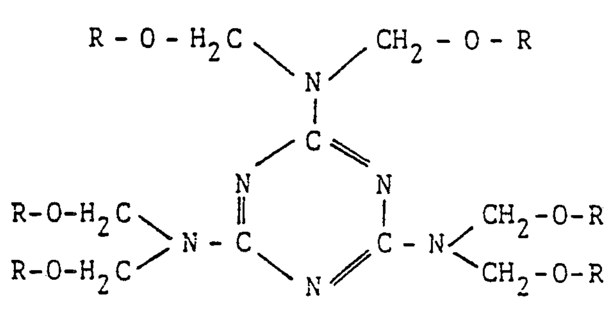

ist, worin R ein Wasserstoffatom oder eine Alkylgruppe bedeutet.

Erfindungsgemäß wird weiterhin ein lichtempfindliches Kopiermaterial vorgeschlagen, das aus einem Schichtträger und einer lichtempfindlichen Schicht aus dem oben definierten Gemisch besteht.

Erfindungsgemäß wird ferner ein Verfahren zur Herstellung einer Druckform vorgeschlagen, bei dem ein lichtempfindliches Kopiermaterial, bestehend aus einem Schichtträger und einer lichtempfindlichen

Schicht, die ein wasserunlösliches, in wäßrig-alkalischen Lösungen lösliches Bindemittel, ein lichtempfindliches o- oder p-Chinondiazid, ein Diazoniumsalz-Polykondensationsprodukt oder ein Gemisch aus

a) einer bei Belichtung Säure abspaltenden Verbindung und

b) einer Verbindung mit mindestens einer durch Säure spaltbaren C—O—C-Gruppe

und eine thermisch vernetzende Verbindung enthält, bildmäßig belichtet wird, die Nichtbildstellen der Schicht mit einer wäßrig-alkalischen Entwicklerlösung ausgewaschen werden und das Material danach zur Verfestigung der Bildschicht auf erhöhte Temperatur erhitzt wird.

Das erfindungsgemäße Verfahren ist dadurch gekennzeichnet, daß die thermisch vernetzende Verbindung ein cyclisches Säureamid der allgemeinen Formel

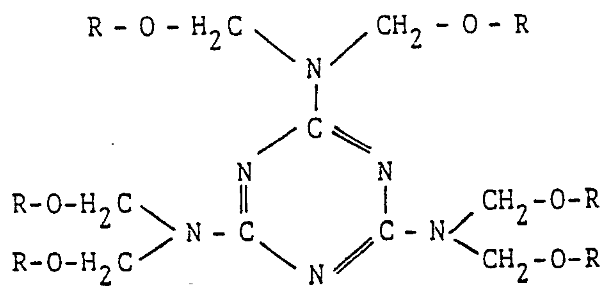

ist, worin R ein Wasserstoffatom oder eine Alkylgruppe bedeutet.

Wegen der relativ schweren Löslichkeit des Hexamethylolmelamins in organischen Lösungsmitteln finden die entsprechenden mindestens teilweise veretherten Verbindungen bevorzugte Anwendung. Die Alkylethergruppen haben im allgemeinen 1-10, vorzugsweise 1-4 Kohlenstoffatome. Die Methylether werden besonders bevorzugt. Auch wird im allgemeinen den Hexaalkylethern vor den partiell veretherten Verbindungen der Vorzug gegeben.

Die Konzentration der thermisch vernetzbaren Melaminverbindungen gemäß der Erfindung in dem lichtempfindlichen Gemisch kann in relativ weiten Grenzen schwanken. Im allgemeinen liegt der Anteil bei 1 bis 20, vorzugsweise zwischen 4 und 10 Gew.-%, bezogen auf das Gewicht der nicht flüchtigen Bestandteile des lichtempfindlichen Gemisches.

Die Reaktionsfähigkeit der Verbindungen mit den vernetzenden Gruppen $—CH_2—O—R$ reicht bei normaler Umgebungstemperatur offenbar nicht zu einer vorzeitigen Vernetzung in der Schicht aus, so daß die im unbelichteten Zustand bei Raumtemperatur gelagerten Kopierschichten eine hohe Lagerfähigkeit aufweisen. Dies ist jedenfalls bei den oben angegebenen bevorzugten Konzentrationen an Vernetzer der Fall, die deutlich niedriger sind als bei den Phenolderivaten der DE-A 30 39 926.

Die erfindungsgemäßen lichtempfindlichen Gemische enthalten ferner eine lichtempfindliche Verbindung. Geeignet sind vor allem positiv arbeitende Verbindungen, d. h. solche, die durch Belichten löslich werden. Hierzu gehören o-Chinondiazide und Kombinationen von photolytischen Säurespendern und säurespaltbaren Verbindungen, wie Orthocarbonsäure- und Acetalverbindungen. Als lichtempfindliche Verbindungen sind ferner p-Chinondiazide und Diazoniumsalz-Polykondensationsprodukte geeignet.

Das erfindungsgemäße Gemisch und Verfahren haben besondere Vorteile in Verbindung mit lichtempfindlichen Materialien auf Basis von o-Chinondiaziden, da deren Auflage durch Einbrennen eine besonders große Erhöhung erfährt. Geeignete Materialien dieser Art sind bekannt und z. B. in der DE-C 938 233, den DE-A 23 31 377, 25 47 905 und 28 28 037 beschrieben. Als o-Chinondiazide werden bevorzugt Naphthochinon-(1,2)-diazid-(2)-4- oder 5-sulfonsäureester oder -amide verwendet. Von diesen werden die Ester, insbesondere die der 5-Sulfonsäure, besonders bevorzugt. Die Menge an o-Chinondiazidverbindungen beträgt im allgemeinen 3 bis 50, bevorzugt 7 bis 35 Gew.-%, bezogen auf die nichtflüchtigen Anteile des Gemischs.

Auch Materialien auf Basis säurespaltbarer Verbindungen lassen sich mit gutem Effekt einbrennen und bei dem erfindungsgemäßen Verfahren einsetzen.

Kopiermaterialien dieser Art sind bekannt und z. B. in den US-A 3 779 778 und 4 101 323, der DE-C 27 18 254 und den DE-A 28 29 512 und 28 29 511 beschrieben. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine.

Von den in der US-A 4 101 323 beschriebenen Orthocarbonsäurederivaten werden besonders die Bis-1,3-dioxan-2-yl-ether von aliphatischen Diolen verwendet.

Von den in der DE-C 27 18 254 beschriebenen Polyacetalen werden diejenigen mit aliphatischen Aldehyd- und Dioleinheiten bevorzugt.

Weitere gut geeignete Gemische sind in der DE-A 29 28 636 beschrieben. Dort werden als säurespaltbare Verbindungen polymere Orthoester mit wiederkehrenden Orthoestergruppen in der Hauptkette beschrieben.

Diese Gruppen sind 2-Alkylether von 1,3-Dioxa-cycloalkanen mit 5 oder 6 Ringgliedern. Besonders

bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 65, vorzugsweise zwischen 14 und 44 Gew.-%, bezogen auf die nichtflüchtigen Bestandteile des Gemischs. Die Menge der Säure abspaltenden Verbindung liegt zwischen 0,1 und 10, vorzugsweise zwischen 0,2 und 5 Gew.-%.

Die erfindungsgemäßen lichtempfindlichen Gemische enthalten ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Zusatz auch bei den erfindungsgemäßen Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd- Kondensationspartner. Die Art und Menge der Novolak-Harze kann je nach Anwendungszweck verschieden sein ; bevorzugt sind Novolak-Anteile am Gesamtfeststoff zwischen 90 und 50, besonders bevorzugt von 80-60 Gew.-%. Zusätzlich können noch zahlreiche andere Harze mitverwendet werden, bevorzugt Vinylpolymerisate wie Polyvinylacetate, Polyacrylate, Polyvinylether, Polyvinylacetale, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. In geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulose-Derivate wie Ethylcellulose, Netzmittel, Farbstoffe, Haftvermittler und feinteilige Pigmente sowie bei Bedarf UV-Absorber enthalten. Als weitere alkalilösliche bzw. in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylenglykol-monoethylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 µm werden meist Metalle verwendet. Für Offsetdruckplatten können eingesetzt werden : walzblankes, mechanisch oder elektrochemisch aufgerauhtes und ggf. anodisiertes Aluminium, das zudem noch chemisch, z. B. mit Polyvinylphosphonsäure, Silikaten, Hexafluorozirkonaten, hydrolysiertem Tetraethylorthosilikat oder Phosphaten, vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag.

Belichtet wird mit den in der Technik üblichen Lichtquellen. Auch das Bestrahlen mit Elektronen oder Laser stellt eine Möglichkeit zur Bebilderung dar.

Die zum Entwickeln verwendeten wäßrig-alkalischen Lösungen abgestufter Alkalität, d. h. mit einem pH, das bevorzugt zwischen 10 und 14 liegt, und die auch kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemäßen lichtempfindlichen Gemische bei der Herstellung von Druckformen, insbesondere Offsetdruckformen, mit Aluminium als Schichtträger.

Nach dem Entwickeln wird die Druckform in an sich bekannter Weise erhitzt. Im Gegensatz zu den bisher beim Einbrennen üblichen Verfahrensbedingungen, wie sie z. B. in der GB-PS 1 154 749 oder der DE-OS 29 39 785 angegeben sind, ist es bei Zusatz der oben definierten Melaminderivate möglich, die gleiche Erhöhung der Druckauflage wie bisher bei deutlich tieferen Temperaturen bzw. innerhalb wesentlich kürzeren Zeiten zu erreichen. Die Einbrenntemperaturen können im Bereich von etwa 150 bis 240 °C, vorzugsweise von 160 bis 210 °C, gewählt werden, wobei normalerweise Erhitzungszeiten von 1-20, bevorzugt 5 bis 10 Minuten, erforderlich sind. Wenn das Trägermaterial gegen höhere Temperaturen beständig ist, ist es selbstverständlich auch möglich, bei höheren Temperaturen oberhalb 240 °C einzubrennen und dementsprechend kurze Erhitzungszeiten zu wählen.

Der nach dem Entwickeln des Bilds freigelegte Schichtträger kann auch in bekannter Weise vor dem Erhitzen mit der wäßrigen Lösung einer filmbildenden Substanz behandelt werden, um die Nachentwicklung nach dem Erhitzen einzusparen oder zumindest zu erleichtern. Diese Behandlung kann auch bei dem erfindungsgemäßen Verfahren nützlich sein, sie ist jedoch nicht erforderlich. Insbesondere bei Anwendung der bevorzugten niedrigen Einbrenntemperaturen bilden sich meist gar keine oder leicht

entfernbare Niederschläge auf den Hintergrundstellen der Platte aus. Bei der bevorzugten Durchführung des Verfahrens kann deshalb auf diesen Schritt verzichtet werden.

Die Erfindung wird anhand der nachfolgenden Beispiele näher erläutert, in denen Gewichtsteile (Gt) und Volumteile (Vt) im Verhältnis von g zu ccm stehen. Prozente sind, wenn nichts anderes angegeben ist, Gewichtsprozente.

Beispiel 1

Mit einer Lösung von

1,40 Gt des Veresterungsproduktes aus 1 mol 2,3,4-Trihydroxy-benzophenon und 3 mol Naphthochinon-(1,2)-diazid-(2)-5-sulfonsäurechlorid,
6,30 Gt eines Kresol-Formaldehyd-Novolaks mit einem Erweichungspunkt von 105-120 °C,
0,20 Gt Naphthochinon-(1,2)-diazid-(2)-4-sulfonsäurechlorid,
0,45 Gt Hexamethylol-melamin-hexamethylether (Cymel 300 der American Cyanamid Corp.) und
0,07 Gt Kristallviolett in
40 Gt Ethylenglykolmonomethylether und
50 Gt Tetrahydrofuran

wurde eine elektrochemisch aufgerauhte und anodisierte Aluminiumplatte beschichtet. Der anodisierte Träger war vor dem Aufbringen der lichtempfindlichen Kopierschicht mit einer wäßrigen Lösung von 0,1 Gew.-% Polyvinylphosphonsäure behandelt worden.

Das so hergestellte vorsensibilisierte Material mit einem Schichtgewicht von ca. 2,0 g/m$^2$ wurde unter einer transparenten Positiv-Vorlage bildmäßig belichtet und anschliessend mit der folgenden Lösung entwickelt:

7,00 Gt Natriummetasilikat × 9 Wasser,
0,02 Gt Strontiumhydroxid × 8 Wasser,
0,03 Gt Lävulinsäure in
93,00 Gt Wasser.

Durch die Entwicklung wurden die vom Licht getroffenen Anteile der Kopierschicht entfernt, und es blieben die unbelichteten Bildstellen auf dem Schichtträger zurück, wobei man die der Vorlage entsprechende Druckschablone erhielt.

Von der so hergestellten Druckform konnten in einer Offsetdruckmaschine 100 000 einwandfreie Drucke hergestellt werden.

Zwecks Erhöhung der Druckauflage und Verfestigung der Druckschablone wurde die Druckform einer Wärmebehandlung unterzogen. Zu diesem Zweck wurde die getrocknete Druckform nach dem Entwickeln in einem Einbrennofen 5 Minuten auf 190 °C erhitzt.

Durch das Erhitzen der Druckform im Ofen trat eine Verfestigung der Druckschablone ein, und die Schicht wurde resistent gegenüber Chemikalien und damit unlöslich in organischen Lösungsmitteln, wie Aceton, Alkoholen, Dimethylformamid, Toluol oder Xylol. In einer Offsetdruckmaschine wurden 350 000 einwandfreie Kopien erhalten.

Wenn der Zusatz von Hexamethylol-melamin-hexamethylether im Beispiel 1 weggelassen wird, wurde nach dem Einbrennen der Druckschablone und unter sonst gleichen Versuchsbedingungen nur eine Druckauflage von 150 000 erhalten. Ferner blieb die Druckschablone in organischen Lösungsmitteln löslich und war auch nicht resistent gegen Korrekturmittel.

Ein wesentlicher Vorteil der Erfindung ist, daß relativ geringe Mengen der erfindungsgemäß verwendeten Verbindungen in der Kopierschicht ausreichen, um die Druckschablone bei einer Temperatur von 180 bis 200 °C innerhalb kurzer Zeit resistent gegenüber Chemikalien zu machen und um eine hohe Druckauflage zu erhalten. Dies wird deutlich beim Vergleich mit den ebenfalls thermisch vernetzenden Methylolverbindungen gemäß DE-A 30 39 926. Ersetzt man beispielsweise im Beispiel 1 den Hexamethylolmelamin-hexamethylether durch die gleiche Menge der besten vernetzbaren Verbindungen gemäß DE-A 30 39 926, z. B. 2,6-Dimethylol-p-kresol oder 2,2-Bis-(4-hydroxy-3,5-dihydroxymethyl-phenyl)-propan, so sind diese Kopierschichten nach fünf Minuten Einbrennen bei 200 °C im Gegensatz zur Kopierschicht entsprechend Beispiel 1 noch nicht resistent gegenüber Chemikalien. Lösungsmittel wie Aceton oder Alkohol sowie Korrekturmittel lösen nach wie vor die eingebrannte Kopierschicht auf.

Erst nach Erhöhung der Menge der Methylolverbindungen in der Kopierschicht um den vier- bzw. zweifachen Betrag wird die Druckschablone nach dem Einbrennen unter gleichen Versuchsbedingungen resistent gegenüber Chemikalien entsprechend der Kopierschicht nach Beispiel 1. Erhöht man die in der DE-A 30 39 926 beschriebenen und hier genannten Methylolverbindungen nicht um den angegebenen Betrag, so ist eine um 40 bis 50 °C höhere Einbrenntemperatur erforderlich, um die Druckschablone chemikalienfest zu erhalten. Diese Temperaturerhöhung hat unter anderem den Nachteil, daß die Formstabilität des Aluminiums als Schichtträger stark nachläßt, was die weitere Handhabung in der Praxis sehr erschwert.

Es ist bekannt, daß die Formstabilität des Aluminiums oberhalb 240 °C irreversibel geringer wird, was die weitere Handhabung derartiger eingebrannter Druckformen in der Praxis sehr erschwert und oftmals sogar unmöglich macht.

Ein weiterer wesentlicher Vorteil der Erfindung liegt darin, daß infolge des relativ niedrigen Anteils der erfindungsgemäß zugesetzten vernetzenden cyclischen Säureamide die bei Temperaturen von 20 bis 40 °C gelagerten vorsensibilisierten Druckplatten eine sehr gute Lagerfähigkeit aufweisen.

Die gute Lagerfähigkeit der Kopiermaterialien entsprechend der Erfindung wird besonders deutlich, wenn man sie bei erhöhter Temperatur, z. B. bei 80 °C, lagert. So lassen sich Musterplatten gemäß der Erfindung nach Beispiel 1 noch nach fünfstündiger Lagerung bei 80 °C nach der Belichtung unter einer Positiv-Vorlage einwandfrei entwickeln und die Druckschablonen mit fetter Farbe einfärben, während die bildfreien Stellen hierbei hydrophil bleiben. Ersetzt man dagegen im Beispiel 1 den Hexamethylol-melamin-hexamethylether durch die gleiche Menge 2,2-Bis-(4-hydroxy-3,5-dihydroxymethyl-phenyl)-propan und lagert diese Platten unter sonst gleichen Versuchsbedingungen ebenfalls bei 80 °C, so sind bereits nach 30 Minuten Lagerung die bildfreien Stellen oleophil geworden, so daß beim Einfärben mit fetter Farbe nicht nur die Druckschablone, sondern auch die Nichtbildstellen der Plattenoberfläche Farbe annehmen.

Ein weiterer Vorteil liegt darin, daß Einbrennöfen mit geringerer Leistung verwendet werden können.

In den folgenden Beispielen werden weitere Beschichtungslösungen angegeben, wobei ähnliche Ergebnisse erhalten wurden. Wenn nicht gesondert vermerkt, entsprechen Herstellung und Verarbeitung der damit erhaltenen Druckplatten den in Beispiel 1 beschriebenen Bedingungen.

Beispiel 2

Mit einer Lösung von

2,80 Gt einer 50 %igen Lösung eines Polyorthoesters in Toluol, hergestellt aus 7,7-Bis-hydroxymethyl-5-oxa-nonanol-(1) und Orthoameisensäuretrimethylester,
0,23 Gt 2-(4-Ethoxy-naphth-1-yl)-4,6-bis-trichlormethyl-s-triazin,
3,30 Gt des in Beispiel 1 angegebenen Novolaks,
0,50 Gt Hexamethylol-melamin-hexamethylether und
0,04 Gt Kristallviolett in
90,00 Gt Butanon

wurde eine elektrochemisch aufgerauhte und anodisierte Aluminiumplatte beschichtet.

Die so hergestellte Druckplatte wurde 10 Sekunden unter einer 5 kW-Metallhalogenidlampe im Abstand von 110 cm bildmäßig belichtet und anschließend mit dem in Beispiel 1 angegebenen Entwickler entwickelt.

Zur Verfestigung der Druckschablone war eine Einbrennzeit von 5 Minuten bei 190 °C ausreichend. Ohne den Zusatz von Hexamethylol-melamin-hexamethylether muß bei 240 °C eingebrannt werden, um eine vergleichbare Resistenz zu erreichen.

Beispiel 3

Mit einer Lösung von

1,36 Gt des Veresterungsproduktes aus 1 mol des Ethoxyethylesters der 4,4-Bis-(4-hydroxyphenyl)-n-valeriansäure und 2 mol Naphthochinon-(1,2)-diazid-(2)-5-sulfonsäurechlorid,
0,18 Gt Naphthochinon-(1,2)-diazid-(2)-4-sulfonsäurechlorid,
4,60 Gt des im Beispiel 1 angegebenen Novolaks,
0,35 Gt Hexamethylolmelamin und
0,07 Gt Kristallviolett in
100 Gt Ethylenglykolmonoethylether

wurde eine elektrochemisch aufgerauhte und anodisierte Aluminiumplatte beschichtet, deren Oberfläche mit einer wäßrigen Lösung von Polyvinylphosphonsäure behandelt worden war.

Zur Verfestigung der Druckschablone war eine Einbrennzeit von 5 Minuten bei 200 °C ausreichend.

Beispiel 4

Mit einer Lösung von

2,0 Gt 1-(4-Methyl-benzolsulfonylimino)-2-(2-ethylphenyl-aminosulfonyl)-benzochinon-(1,4)-diazid-(4),
0,5 Gt eines mit Chloressigsäure modifizierten Kresol-Formaldehyd-Novolaks (beschrieben in Beispiel 5 der DE-A 1 053 930),

2,0 Gt des in Beispiel 1 angegebenen Novolaks und
0,5 Gt Hexamethylol-melamin-hexabutylether in
60 Gt Ethylenglykolmonomethylether und
15 Gt Butylacetat

wurde eine durch Drahtbürsten mechanisch aufgerauhte Aluminiumplatte beschichtet.

Zur Verfestigung der Druckschablone war eine Einbrennzeit von 5 Minuten bei 190 °C ausreichend.

Beispiel 5

Mit einer Lösung von

2,5 Gt Bis-(5-ethyl-5-butyl-1,3-dioxan-2-yl)-ether des 2-Ethyl-2-butyl-1,3-propandiols,
7,1 Gt Kresol-Formaldehyd-Novolak wie im Beispiel 1,
0,3 Gt 2-(Acenaphth-5-yl)-4,6-bis-trichlormethyl-s-triazin,
0,7 Gt Kristallviolett-Base und
0,5 Gt Hexamethylolmelamin-hexamethylether in
90 Gt Ethylenglykolmonomethylether

wurde eine elektrochemisch aufgerauhte und anodisierte Aluminiumplatte beschichtet.

Zur Verfestigung der Druckschablone war eine Einbrennzeit von 5 Minuten bei 190 °C ausreichend.

Ähnliche Ergebnisse wurden erhalten, wenn statt des angegebenen Orthoesterderivats ein Polyacetal verwendet wurde, wie es in der DE-A 27 18 254 beschrieben ist.

**Patentansprüche**

1. Lichtempfindliches Gemisch, das ein wasserunlösliches, in wäßrig-alkalischen Lösungen lösliches Bindemittel, ein lichtempfindliches o- oder p-Chinondiazid, ein Diazoniumsalz-Polykondensationsprodukt oder ein Gemisch aus
   a) einer bei Belichtung Säure abspaltenden Verbindung und
   b) einer Verbindung mit mindestens einer durch Säure spaltbaren C—O—C-Gruppe

und eine thermisch vernetzende Verbindung enthält, dadurch gekennzeichnet, daß die thermisch vernetzende Verbindung ein cyclisches Säureamid der allgemeinen Formel

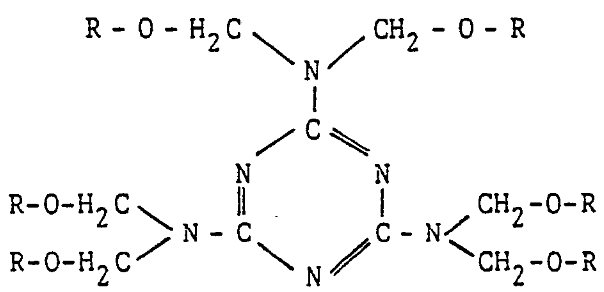

ist, worin R ein Wasserstoffatom oder eine Alkylgruppe bedeutet.

2. Lichtempfindliches Gemisch nach Anspruch 1, dadurch gekennzeichnet, daß es das cyclische Säureamid in einer Menge von 1 bis 20 Gew.-%, bezogen auf das Gewicht der nichtflüchtigen Bestandteile, enthält.

3. Lichtempfindliches Gemisch nach Anspruch 1, dadurch gekennzeichnet, daß das in wäßrig-alkalischen Lösungen lösliche Bindemittel ein Novolak ist.

4. Lichtempfindliches Kopiermaterial, bestehend aus einem Schichtträger und einer lichtempfindlichen Schicht, die ein wasserunlösliches, in wäßrig-alkalischen Lösungen lösliches Bindemittel, ein lichtempfindliches o- oder p-Chinondiazid, ein Diazoniumsalz-Polykondensationsprodukt oder ein Gemisch aus
   a) einer bei Belichtung Säure abspaltenden Verbindung und
   b) einer Verbindung mit mindestens einer durch Säure spaltbaren C—O—C-Gruppe

und eine thermisch vernetzende Verbindung enthält, dadurch gekennzeichnet, daß die thermisch vernetzende Verbindung ein cyclisches Säureamid der allgemeinen Formel

(Voir Figure page 8)

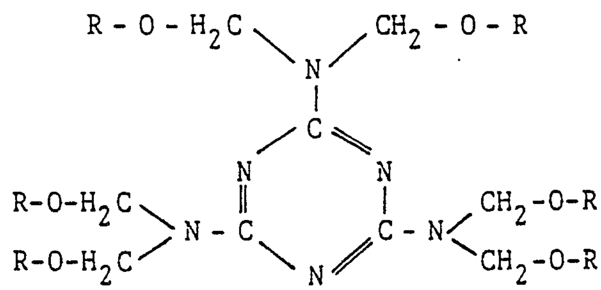

ist, worin R ein Wasserstoffatom oder eine Alkylgruppe bedeutet.

5. Verfahren zur Herstellung einer Druckform, bei dem ein lichtempfindliches Kopiermaterial, bestehend aus einem Schichtträger und einer lichtempfindlichen Schicht, die ein wasserunlösliches, in wäßrig-alkalischen Lösungen lösliches Bindemittel, ein lichtempfindliches o- oder p-Chinondiazid, ein Diazoniumsalz-Polykondensationsprodukt oder ein Gemisch aus

a) einer bei Belichtung Säure abspaltenden Verbindung und

b) einer Verbindung mit mindestens einer durch Säure spaltbaren C—O—C-Gruppe

und eine thermisch vernetzende Verbindung enthält, bildmäßig belichtet wird, die Nichtbildstellen der Schicht mit einer wäßrig-alkalischen Entwicklerlösung ausgewaschen werden und das Material danach zur Verfestigung der Bildschicht auf erhöhte Temperatur erhitzt wird, dadurch gekennzeichnet, daß die thermisch vernetzende Verbindung ein cyclisches Säureamid der allgemeinen Formel

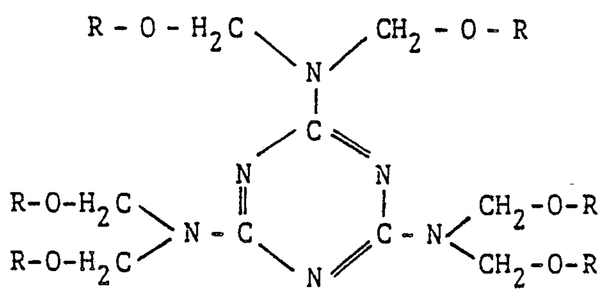

ist, worin R ein Wasserstoffatom oder eine Alkylgruppe bedeutet.

**Claims**

1. A light-sensitive composition which comprises a water-insoluble binder which is soluble in aqueous-alkaline solutions ; and a light-sensitive component selected from the group consisting of o- or p- quinone diazides, diazonium salt polycondensation products, or a mixture of

a) a compound which eliminates an acid on exposure to light and

b) a compound having at least one C—O—C group which can be split by acid ;

and a thermo-crosslinking compound, which thermo-crosslinking compound is a cyclical acid amide of the general formula :

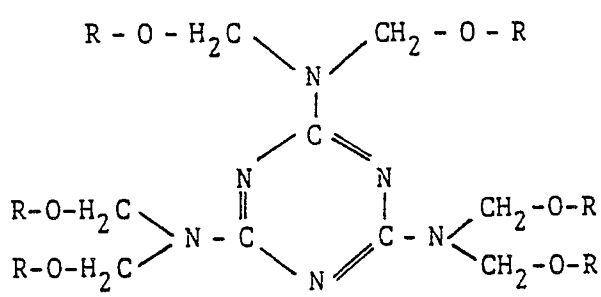

wherein R denotes a hydrogen atom or an alkyl group.

2. The light-sensitive composition of Claim 1, wherein the cyclical acid amide is present in an amount of between 1 and 20 percent by weight.

3. The light-sensitive mixture of Claim 1, wherein the binder which is soluble in aqueous-alkaline solutions is a novolak resin.

4. A photosensitive copying material which comprises a support and a light-sensitive layer on said support, said layer comprising a water-insoluble binder, which is soluble in aqueous-alkaline solutions ;

and a light-sensitive component selected from the group consisting of o- or p- quinone-diazides, diazonium salt polycondensation products or a mixture of

a) a compound which eliminates an acid on exposure to light and

b) a compound having at least one C—O—C group which can be split by acid ;

and a thermo-crosslinking compound, which thermo-crosslinking compound is a cyclical acid amide of the general formula :

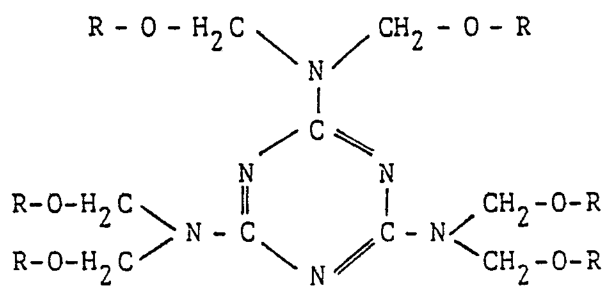

wherein R denotes a hydrogen atom or an alkyl group.

5. A process for the preparation of a printing form, in which a photosensitive copying material comprising a support and a light-sensitive layer on said support, which layer comprises a water-insoluble binder, which is soluble in aqueous-alkaline solutions, and a light-sensitive component selected from the group consisting of o- or p- quinone-diazides, diazonium salt polycondensation products or a mixture of

a) a compound which eliminates an acid on exposure to light and

b) a compound having at least one C—O—C group which can be split by acid ;

and a thermo-crosslinking compound is imagewise exposed, the non-image areas of the layer are removed with an aqueous-alkaline developer solution ; and the material is then heated to an elevated temperature sufficient to harden the image layer, wherein said thermo-crosslinking compound is a cyclical acid amide of the general formula :

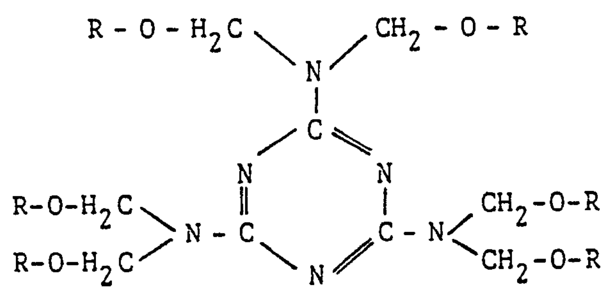

wherein R denotes a hydrogen atom or an alkyl group.

## Revendications

1. Mélange photosensible, qui contient un liant insoluble dans l'eau et soluble dans des solutions aqueuses alcalines, un o- ou p-quinone-diazide photosensible, un produit de polycondensation d'un sel de diazonium, ou un mélange constitué

a) d'un composé libérant un acide à l'exposition, et

b) d'un composé comportant au moins un groupe C—O—C dissociable par un acide,

et un composé réticulable à la chaleur, caractérisé en ce que le composé réticulable à la chaleur est un amide cyclique de formule générale

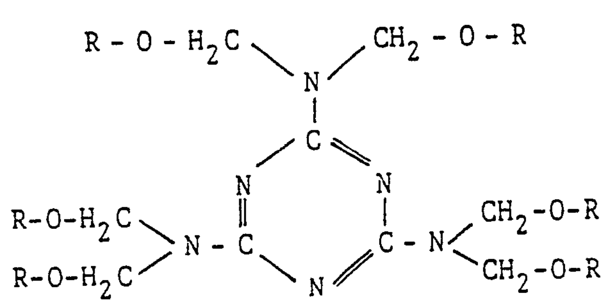

dans laquelle R représente un atome d'hydrogène ou un groupe alkyle.

2. Mélange photosensible selon la revendication 1, caractérisé en ce qu'il contient l'amide cyclique en une quantité allant de 1 à 20 % en poids, par rapport au poids des composants non volatils.

3. Mélange photosensible selon la revendication 1, caractérisé en ce que le liant soluble dans des solutions aqueuses alcalines est une Novolaque.

4. Matériau de copie photosensible composé d'un support de couche et d'une couche photosensible qui contient un liant insoluble dans l'eau et soluble dans des solutions aqueuses alcalines, un o- ou p-quinone-diazide photosensible, un produit de polycondensation d'un sel de diazonium ou un mélange constitué

a) d'un composé libérant un acide à l'exposition, et

b) d'un composé comportant au moins un groupe C—O—C dissociable par un acide,

et un composé réticulable à la chaleur, caractérisé en ce que le composé réticulable à la chaleur est un amide cyclique de formule générale

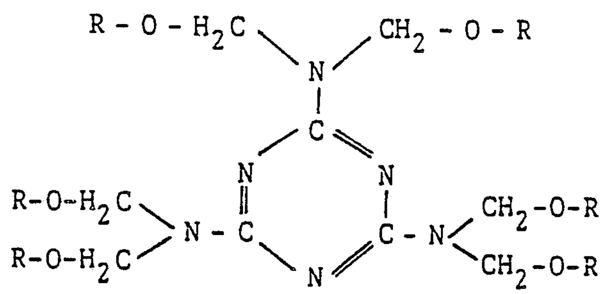

dans laquelle R représente un atome d'hydrogène ou un groupe alkyle.

5. Procédé pour la préparation d'une forme d'impression, dans lequel un matériau de copie photosensible, composé d'un support de couche et d'une couche photosensible qui contient un liant insoluble dans l'eau et soluble dans des solutions aqueuses alcalines, un o- ou p-quinone-diazide photosensible, un produit de polycondensation d'un sel de diazonium, ou un mélange constitué

a) d'un composé libérant un acide à l'exposition, et

b) d'un composé comportant au moins un groupe C—O—C dissociable par un acide,

et un composé réticulable à la chaleur, est exposé selon une image, les zones de non-image de la couche sont éliminées par lavage avec une solution aqueuse alcaline de développement, et on chauffe ensuite le matériau à une température élevée pour faire durcir la couche d'image, caractérisé en ce que le composé réticulable à la chaleur est un amide cyclique de formule générale.

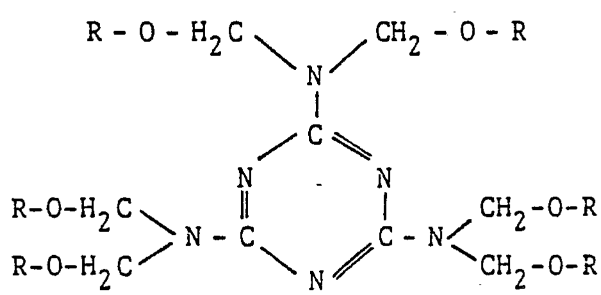

dans laquelle R représente un atome d'hydrogène ou un groupe alkyle.